# EUROPEAN PATENT SPECIFICATION

(11) **EP 3 018 488 B1**
(45) Date of publication and mention of the grant of the patent: **07.06.2023**
(21) Application number: 14306785.8
(22) Date of filing: 06.11.2014
(51) Int. Cl.: G01R 33/28

(54) **An MRI device and a method for recognizing implanted pacemakers**
MRT-Vorrichtung und Verfahren zur Erkennung implantierter Herzschrittmacher
Dispositif IRM et procédé pour reconnaître des régulateurs cardiaques implantés

(43) Date of publication of application: 11.05.2016
(73) Proprietor: Université de Lorraine, 54001 Nancy Cedex (FR); Centre Hospitalier Régional de Nancy, 54035 Nancy Cedex (FR); Schiller Medical SAS, 67162 Wissembourg Cedex (FR)
(72) Inventor: Meyer, Didier, 67160 Oberhoffen-lès-Wissembourg (FR); Felblinger, Jacques, 54850 Méréville (FR); Petitmangin, Gregory, 67480 Roeschwoog (FR)
(74) Representative: Müller, Christoph Emanuel

(56) References cited:
- EP-A1- 1 872 717
- WO-A1-02/087696
- IL-A- 47 278
- US-A1- 2010 191 095
- ACHENBACH ET AL: "Effects of magnetic resonance imaging on cardiac pacemakers and electrodes", AMERICAN HEART JOURNAL, MOSBY- YEAR BOOK INC, US, vol. 134, no. 3, 1 September 1997 (1997-09-01), pages 467-473, XP005119739, ISSN: 0002-8703, DOI: 10.1016/S0002-8703(97)70083-8
- ERLEBACHER J A ET AL: "Effect of magnetic resonance imaging on DDD pacemakers", AMERICAN JOURNAL OF CARDIOLOGY, CAHNERS PUBLISHING CO., NEWTON, MA, US, vol. 57, no. 6, 15 February 1986 (1986-02-15), pages 437-440, XP023209528, ISSN: 0002-9149, DOI: 10.1016/0002-9149(86)90768-X [retrieved on 1986-02-15]
- S. NAZARIAN: "Clinical Utility and Safety of a Protocol for Noncardiac and Cardiac Magnetic Resonance Imaging of Patients With Permanent Pacemakers and Implantable-Cardioverter Defibrillators at 1.5 Tesla", CIRCULATION, vol. 114, no. 12, 19 September 2006 (2006-09-19), pages 1277-1284, XP055169520, ISSN: 0009-7322, DOI: 10.1161/CIRCULATIONAHA.105.607655
- T. SOMMER: "Strategy for Safe Performance of Extrathoracic Magnetic Resonance Imaging at 1.5 Tesla in the Presence of Cardiac Pacemakers in Non-Pacemaker-Dependent Patients: A Prospective Study With 115 Examinations", CIRCULATION, vol. 114, no. 12, 19 September 2006 (2006-09-19), pages 1285-1292, XP055169522, ISSN: 0009-7322, DOI: 10.1161/CIRCULATIONAHA.105.597013
- KAASALAINEN TOUKO ET AL: "MRI with cardiac pacing devices - Safety in clinical practice", EUROPEAN JOURNAL OF RADIOLOGY, vol. 83, no. 8, 1 May 2014 (2014-05-01), pages 1387-1395, XP028859208, ISSN: 0720-048X, DOI: 10.1016/J.EJRAD.2014.04.022
- PETRUTIU S ET AL: "High resolution electrocardiography optimised for recording pulses from electronic pacemakers: Evaluation of a new pacemaker sensing system", COMPUTERS IN CARDIOLOGY, 2007, IEEE, PISCATAWAY, NJ, USA, 30 September 2007 (2007-09-30), pages 197-200, XP031404681, ISBN: 978-1-4244-2533-4
- ERIC D. HELFENBEIN ET AL: "A software-based pacemaker pulse detection and paced rhythm classification algorithm", JOURNAL OF ELECTROCARDIOLOGY, vol. 35, no. 4, 1 October 2002 (2002-10-01), pages 95-103, XP055049148, ISSN: 0022-0736, DOI: 10.1054/jelc.2002.37161
- ABÄCHERLI R ET AL: "Suppression of MR gradient artefacts on electrophysiological signals based on an adaptive real-time filter with LMS coefficient updates", MAGNETIC RESONANCE MATERIALS IN PHYSICS, BIOLOGY AND MEDICINE, CHAPMAN AND HALL, LONDON, GB, vol. 18, no. 1, 1 March 2005 (2005-03-01), pages 41-50, XP019358194, ISSN: 1352-8661
- Torsten Sommer ET AL: "MR Imaging and Cardiac Pacemakers: In Vitro Evaluation and in Vivo Studies in 51 Patients at 0.5 T", RADIOLOGY, vol. 215, no. 3, 1 June 2000 (2000-06-01), pages 869-879, XP055672896, US ISSN: 0033-8419, DOI: 10.1148/radiology.215.3.r00jn08869

## Description

The present invention relates to an MRI device and a method for recognizing implanted pacemakers set in asynchronous mode.

It is estimated that up to 75% of patients with implanted pacemakers develop an indication for magnetic resonance imaging (MRI) examination. MRI, however, provides some potential adverse effects on implanted pacemakers such as radiofrequency-induced heating of lead tips, pacing inhibition/dysfunction, asynchronous pacing with the possibility of induction of atrial or ventricular tachycardies or arrhythmias, transient reed switch activation, change or loss of programmed data and changes in capture threshold. Such adverse effect are possible too for pacemaker given as MR compatible because limitation given in the range of use of them is very restrictive and not always followed.

It is therefore necessary for a person such as a radiographer, an MR operator or a radiologist, operating the MRI device to know if a patient is wearing a pacemaker and if the pacemaker is working properly. The operator may then monitor the pacemaker during the MRI examination.

Before starting the MRI, it is mandatory that the pacemakers are set in an asynchronous mode by the cardiologist in order to reduce the risk of inappropriate inhibition of pacing due to detection of electromagnetic interference. In the asynchronous mode the pacemaker generates asynchronous stimulation spikes followed by a cardiac activity display by the QRS on an ECG trace at a fixed frequency such that the heart beats in a regular interval. The setting of the pacemaker is often performed by medical staff different from the user of the MRI device. The user of the MRI device does therefore not necessary know that the patient is wearing a pacemaker.

An automatic information system to inform the presence and preferably the good functioning of the pacemaker by the MR user is therefore favourable.

EP 1 872 717 A1 discloses a method to detect the presence of a pacemaker in an ECG signal carried out with an ECG monitor.

IL 47 278 A discloses an ECG monitor with the ability to detect spikes from a pacemaker and display results including an evaluation of the pacemaker rate.

US 2008/281187 A1 proposes the use of detection stations to detect pacemakers. A patient is passed underneath three detection stations in order to magnetize ferromagnetic objects, e.g. pacemakers. The magnetized objects are then sensed with sensors of the detection stations.

The detection is rather complicated as an external magnetization has to be used. Further, a special arrangement outside the MRI device is needed to sense pacemakers. Additionally, this detection device is not used in standard clinical setups.

DE 10 2006 016 043 A1 proposes to provide heart pacemakers with an RFID transponder. The MRI device is equipped with a control unit, which has a connection to a processing unit bearing a RFID receiver. Therewith, the pacemaker can be detected by the MRI device.

*"*Effects of magnetic resonance imaging on cardiac pacemakers" published in Am. Heart J 19107; 134:467-73 discloses a phantom study. Electrodes were connected to the surface of the isolated heart. During examination a combination of a diode and a capacitor is connected to the pacemakers parallel to the electrode, which allowed a wider pacemaker signal.

The detection is based on RFID. Therefore, a transponder has to be present in the pacemaker. The device is not suitable for a detection of pacemakers without a transponder.

It is an object of the present invention to overcome the disadvantages of the prior art, in particular to provide a device for detecting implanted pacemakers in a simple and reliable way and to improve the safety for patients wearing a pacemaker during an MRI.

The object is achieved by a method and an MRI device according to the independent claims.

In particular, the object is achieved with an MRI device for use with a patient having an implanted pacemaker. The MRI device comprises an ECG monitor configured to directly or indirectly detect spikes generated by the implanted pacemaker before and/or during MRI examination. The spikes are automatically detected. Spikes as mentioned herein are vertical signals that represent the electrical activity of the pacemaker.

Spikes are only present in a patient wearing a pacemaker. Therefore, a device configured to detect spikes is able to determine if a pacemaker is present. The detection of spikes provides an easy and reliable method to estimate if a pacemaker is present. The monitor is preferably arranged directly on the patient. Alternatively, the monitor is arranged at distance from the patient, e.g. on the outside of the MRI device.

The monitor is configured to determine if detected spikes fulfil a predetermined regularity pattern.

In a patient wearing a heart pacemaker set in asynchronous mode, the emitted spikes are completely regular. Therefore, a device being configured to detect a predetermined regularity pattern is able to detect if a pacemaker set in asynchronous mode is present. The time difference between the pulses over the time is therefore basically constant, i.e. | tᵢ-tᵢ₋₁ |/tᵢ ≤ 2%

There should be at least 10 pulses in order to have an average pulse frequency, which can be checked for a regularity pattern.

Preferably, the monitor checks first the presence of pacemaker spike for a first level indication and then for regularity pattern before the MRI examination starts. To perform the MRI examination, the patient is placed in an MRI tube. Preferably the monitor checks for spikes with a regularity pattern when the patient is in the tube but before the examination starts. Therewith, the operator knows if the patient is wearing a pacemaker before the MRI examination even starts.

Pacemakers are preferably set to 60 to 80 pulses per minute in asynchronous mode. A pacemaker is basically never set higher than 100 pulses per minute by a cardiologist. If such a high number is detected, the operator knows that the pacemaker is not set in a correct asynchronous mode.

It is still possible that the heart will go faster e.g. due to stress in a patient wearing a pacemaker set in asynchronous mode. Therefore, only the spikes should be controlled in order to determine if the pacemaker is set in asynchronous mode as the QRS pulse might still be (slightly) variable. However, standard threshold on brady and tachy are still necessary. Preferably, a monitoring system checks the frequency of the QRS pulse. If an asystolie arises e.g. an alarm is preferably activated to inform an operator.

There is no need to provide the pacemaker with e.g. an additional transponder in order to detect it. The pacemaker provides spikes to generate heart beats and these spikes are recognized. As the pacemaker is set in an asynchronous mode before MRI examination, the spikes provide a completely regular pattern with a shape that is different from a QRS complex. The spikes are therefore distinguishable from a natural beating pattern of the heart, where no spikes are present.

The monitor is preferably configured to determine if a QRS pulse is present after any of the spikes.

A QRS pulse is generated by a beating heart. Therefore, after the spikes are detected, a QRS pulse should be detected. If no QRS pulse is detected the heart is not beating. The presence of spikes and a QRS pulse is therefore an indication of a patient wearing a pacemaker having a beating heart.

The device comprises a prompting element configured to inform an operator if spikes are present. Preferably, the prompting element informs the user visually and/or acoustically. By adding a prompting element, the user is informed of the presence of spikes. The user hence knows that the patient is wearing a pacemaker. A visual information might e.g. be provided on a screen with a text or with a blinking light. An acoustic information might e.g. be an announcement through a speaker or a specific jingle.

The prompting element is configured to inform the operator if the spikes fulfil the predetermined regularity pattern. Preferably, the prompting element informs the user visually and/or acoustically.

By informing the user about the regularity of the pattern, the user is informed if the patient is wearing a pacemaker set in asynchronous mode. Therewith, the operator knows that an MRI examination can be performed. Because a pacemaker has to be set in asynchronous mode in order to reduce the risk of inappropriate inhibition of pacing the operator should know if the pacemaker is in asynchronous mode prior to start MRI examination.

The user is preferably also informed acoustically and/or visually if more than a certain number of pulses per minutes are present. The user might be informed by the prompting element if more than 100 pulses are present. A pacemaker is not set in an asynchronous mode with such a high number of pulses. Therefore, it is preferable to inform the user if there are more than 100 pulses to let him know that something is wrong with the pacemaker or the programming of the pacemaker, respectively.

The prompting element is preferably configured to inform the operator if a QRS pulse is present after any of the spikes or not. By informing the user of the presence of a QRS pulse, the user knows that the pacemaker and the heart work. Only a patient having a regular spike pattern and a QRS pulse thereafter has a normal beating heart. If no QRS pulse is present, the heart of the patient is not beating. The user might than provide assistance such as CPR or defibrillation to the patient.

The prompting element is preferably additionally or alternatively configured to provide an alarm to the operator if detected spikes do not fulfil the predetermined regularity pattern any more if a regularity pattern had been detected. For this purpose, the fact that a regularity pattern previously had been detected can be stored, e.g. by setting an appropriate flag. When the fact is stored and a non-regular pattern is detected, the prompting element can inform the operator with an alarm. Preferably, this alarm is visual or acoustic.

If the detected spikes do not fulfil the predetermined regularity pattern during the MRI examination anymore or if they are absent, there is probably an interference of the MRI with the pacemaker. By informing the operator of the MRI that the spikes are not fulfilling the predetermined regularity pattern anymore, the operator can e.g. stop the MRI examination.

The visual and/or acoustic information might be provided with the similar means as the information in case of the detection of the predetermined regularity pattern.

The device preferably further comprises a control interface. The control interface is configured to communicate with the MRI device and to stop the MRI examination in case of non-fulfilment of such regularity pattern if a regularity pattern has been detected before.

As described above, a non-regular spike pattern in a patient having a pacemaker set in asynchronous mode is a strong indication for an interference of the MRI activity with the pacemaker. As such interferences might have serious consequences to the patient up to mortality, the MRI examination should be stopped. By providing a control interface, the MRI examination might automatically be stopped if the regularity pattern of the spikes ceases.

Preferably, the control interface is only started during MRI examination and stopped with the MRI examination. The control interface might be started and/or stopped by the operator. Alternatively, the control interface might be started and/or stopped automatically with the beginning/end of the MRI examination.

By stopping the MRI examination upon detection of non-regular spike patterns, the interference of the MRI activity with the pacemaker is kept short. Therewith, the risk of consequences for the patient is reduced. Further, e.g. the operator might check the state of the patient for indications of problems as soon as the examination is stopped.

The monitor preferably further comprises a magnetic field variation detector information with or without a dedicated magnetic resonance field detector. Alternatively or additionally, the monitor comprises an RF artefact detector. Such a monitor is configured to detect magnetic resonance and/or RF artefacts generated by the MRI activity. Further, the monitor is preferably configured to distinguish such artefacts from the monitored spikes.

The monitor preferably comprises a magnetic field variation detector as described in EP 2 152 157. The magnetic field detector variation detector is preferably configured to detect the presence of switching magnetic field (gradient of magnetic field used for imaging) that are the origin of artefacts on the ECG trace. The MRI system is aware of the generation of gradient magnetic fields. The detector might therefore be an external sensor or information coming from the MRI system itself. Preferably a Hall sensor in the amplifier provides signal of the disturbance input. The detector is preferably able to detect the impulse response between the disturbance input and the artefact on an ECG trace. On the basis of the impulse response, the convolution can be calculated and the artefacts can be detected and removed from the ECG trace. Preferred methods are described in the scientific papers *"*Restoration of Electrophysiological Signals Distorted by Inductive Effects of Magnetic Field Gradients During MR Sequences" in "Magnetic Resonance in Medicine 41: 715-721 (1999)" by J. Felblinger et al. and *"*Suppression of MR gradient artefacts on electrophysiological signals based on an adaptive real-time filter with LMS coefficient updates" in MAGMA 18: 41-50 (2005)" by R. Abächerli et al.

Further, the linear impulse response between this magnetic field detector and the artefact on ECG is known so that Pacemaker spikes and artefact on ECG trace caused by MR gradient could be separated. The magnetic field detector associated with signal processing is configured to distinguish such artefacts from the monitored spikes. The distinction has been described in in EP 2 152 157.

In general artefacts have a lower dV/dt than spikes. This knowledge aid in the detection of the artefacts.

By detecting the artefacts of the MRI activity and distinguish them from the monitored spikes, the chances of a false alarm are reduced. The artefacts might arise in a non-regular pattern. Hence, if not distinguished from the spikes but detected, a possible prompting element or a possible control interface might wrongly be activated even if the pacemaker still fulfils the predetermined regularity pattern.

The invention is further directed to a method for recognizing pacemakers. The method is carried out with an ECG monitor. Preferably the pacemakers are recognized with an MRI device as described herein before or a monitor as described herein. The method comprises the step of detecting generated spikes of the pacemaker before and optionally during MRI examination.

The spikes are automatically detected.

As described above, spikes are only presence in a patient wearing a pacemaker. Hence, by detecting spikes a pacemaker can be detected.

It is determined if the monitored spikes fulfil a predetermined regularity pattern.

By determining if the spikes fulfil the predetermined regularity pattern, the method is able to determine if the patient is wearing a pacemaker set in asynchronous mode.

It is preferably further determined if a QRS pulse is present after the monitored spikes.

Therewith, it can be ensured that the heart of the patient is beating.

The method comprises the further step of informing an operator with a prompting device if spikes are present. The operator is preferably visually and/or acoustically informed.

As described above, the information might e.g. be displayed on a screen or transmitted via a speaker. The operator is therefore informed in case the patient is wearing a pacemaker.

The operator is informed if the spikes fulfil the predetermined regularity pattern.

The operator is preferably also informed if a QRS pulse is present or not after the spikes.

Preferably, the method comprises the further step of informing the operator with a prompting device if the spikes do not fulfil the predetermined regularity pattern anymore if a regularity pattern had been detected before. The user is preferably visually and/or acoustically informed.

Again the information might e.g. be displayed on a screen or transmitted via a speaker. If the spikes do not fulfil the predetermined regularity pattern anymore during MRI examination, there is a considerable risk that the MRI interferes with the pacemaker. The monitor preferably informs the operator. The operator might be able to stop the MRI examination. This reduces the risk of serious harms to the patient.

Preferably, the method comprises the step of generating a stop signal for stopping the MRI examination if the monitor detects spikes not fulfilling such regularity pattern anymore if a regularity pattern had been detected before.

By an automatic stop of the MRI examination in case of a detection of a non-regular spike pattern in a patient wearing a pacemaker, the interference of the MRI with the pacemaker is minimized. Therefore, the risk of serious harms for the patient is also minimized.

Preferably, the method comprises the further step of detecting artefacts generated by the MRI activity with a magnetic field detector. The magnetic field detector is further configured to distinguish the monitored spikes from the artefacts.

The detection of artefacts is performed as described hereinbefore.

The distinction between artefacts and spikes reduces the risk of false alarms. The artefacts have a non-regular pattern. By distinguishing these artefacts from the spike pattern, the possible monitor will not falsely alarm an operator of a non-regular artefact pattern if the spikes are still regular.

The monitor used in the MRI device according to the invention and in the method according to the invention is configured to detect emitted spikes of a heart pacemaker before MRI examination.

The monitor is an ECG monitor. The monitor is configured to determine spikes are present. The spikes are automatically detected.

Such a monitor might be used as an add-on on an MRI device, which has not been able to detect emitted spikes during MRI examination so far.

The monitor is further configured to determine if the detected spikes fulfil a predetermined regularity pattern. Therewith, it is known if the pacemaker is set in asynchronous mode.

The monitor is preferably further configured to determine if a QRS pulse is present after the detected spikes.

Therewith, it is known if the heart is beating.

The monitor comprises a prompting element. The prompting element is configured to inform an operator if spikes are present. The prompting element informs preferably visually and/or acoustically.

Therewith, the operator is informed if the patient is wearing a pacemaker. As described above, the information might e.g. be displayed on a screen or transmitted via a speaker.

The prompting element is configured to inform the operator if the spikes fulfil a predetermined regularity pattern. Therewith, the operator is informed if the pacemaker is set in asynchronous mode.

The prompting element is preferably configured to inform the operator if a QRS pulse is present after any of the spikes or not. Therewith, the operator is informed if the heart of the patient is beating or not.

The monitor preferably comprises a prompting element configured to provide an alarm in case the detected spikes not fulfilling the predetermined regularity pattern anymore if a regularity pattern had been detected before. The prompting element alarms preferably visually and/or acoustically.

Therewith, the operator is informed if the pacemaker does not emit a regular pattern anymore. The non-regular patter is an indication of interference of the MRI with the pacemaker. As described above, the information might e.g. be displayed on a screen or transmitted via a speaker.

The operator might stop the MRI examination because of the alarm.

The monitor preferably further comprises a control interface. The control interface is configured to communicate with an MRI device and to stop an MRI examination in case of non-fulfilment of such regularity pattern if a regularity pattern previously had been detected before.

As described hereinbefore, the control interface might be started and/or stopped by the operator or automatically.

Therewith, the MRI examination might automatically be stopped in case of the detection of non-regular patterns that could be dangerous for the patient. The risk for serious harms is reduced as the time of interference of the MRI and the pacemaker is minimized.

Preferably, the monitor further comprises magnetic field variation detector information with or without a dedicated magnetic resonance field detector. Additionally or alternatively, the monitor comprises an RF artefact detector. The monitor is preferably configured to detect magnetic resonance and/or RF artefacts generated by the MRI activity and which is configured to distinguish such artefacts from the monitored spikes.

Artefacts which might have a non-regular pattern can be distinguished from the spike pattern. Such a pattern is the comparison of multiple spikes. Preferably at least ten spikes are compared to decide on their regularity. Therewith, the risk of a false alarm because of a detection of a non-regular pattern if in fact a regular pattern is present is reduced.

The inventive method may be carried out with a computer program product comprising software code portions for performing the steps of the method as described hereinabove. The description is in the following described with reference to schematic drawings, which show non-limiting examples of the invention.

The figures show:
- Fig. 1:: a schematic view of an MRI device according to the invention;
- Fig. 2:: a flow chart illustrating a decision process according to the invention;
- Fig. 3:: ECG diagram of an asynchronous pattern.

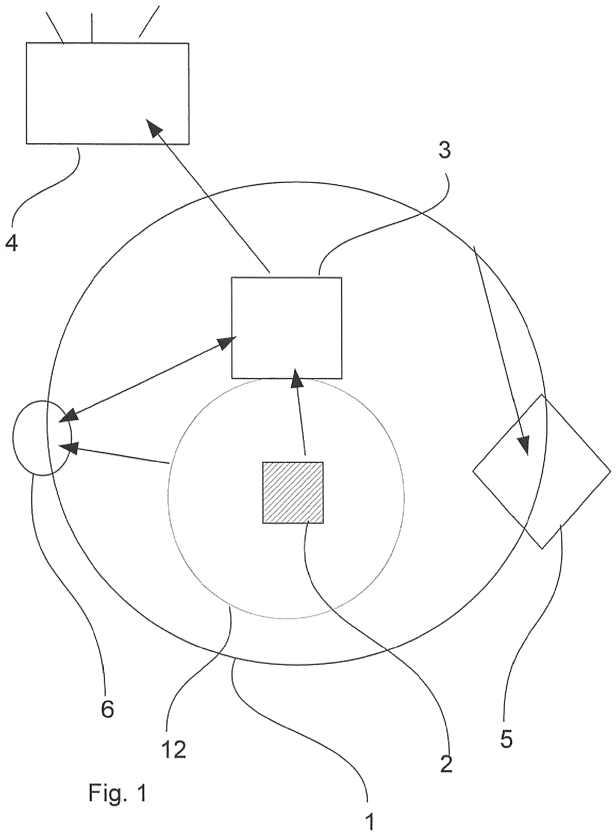

Figure 1 shows a schematic view of an MRI device 1 according to the invention. A patient 12 is placed in the MRI tunnel for an MRI examination. The patient 12 is wearing an implanted pacemaker 2. The pacemaker 2 has been set in an asynchronous mode prior to the MRI examination. Therefore, the pacemaker 2 generates spikes with a predetermined, regular frequency pattern.

An ECG monitor 3 is determining the ECG of the patient 12. Before the MRI examination starts, the ECG monitor 3 determines if spikes with a regular, predetermined frequency pattern are present. As the patient 12 is wearing a pacemaker 2 in asynchronous mode, the monitor 3 will detect such regular pattern. Because of the completely regular pattern, the monitor 3 recognizes that the patient 12 is wearing a pacemaker 2. The monitor is directly arranged on the patient 12.

The monitor 3 detects spike maximum and shape of the spikes. As spikes have another shape than the QRS, the shape is an indication for spikes. Spike to spike to spike interval is also determined. A constant interval is considered to form a regular pattern. Hence, | tᵢ-tᵢ₋₁ | / tᵢ ≤ 2% is considered as a regular pattern

The monitor 3 waits for at least ten pulses. The intervals between the ten pulses is compared in order to determine if the spikes fulfil the regularity pattern.

The MRI device 1 further comprises a prompting element 4 in the form of a speaker. Upon recognition from the monitor 3 that the patient is wearing a pacemaker 2, the monitor provides a signal to the prompting element 4 in the form of an acoustic alarm. The prompting element 4 provides an operator of the MRI device 1 with the information that the patient 12 is wearing an implanted pacemaker 2. The prompting element 4 is therefore placed in an operator room (not shown).

During the MRI examination the ECG monitor 3 continues to monitor the ECG of the patient 12.

A magnetic field detector 6 is able to detect artefacts generated by the magnetic field of the MRI device 1 and to distinguish them from the detected spikes. The field detector 6 provides the information to the monitor 3 such that the monitor only measures the spikes of the pacemaker without the artefacts. Therefore, the monitor 3 does not wrongly detect non-regular patterns if the pattern is in fact still regular but an irregular artefact pattern is present.

If the monitor 3 detects that the regular spikes ceases to exist, the monitor 3 provides a signal to the prompting element 4 and to a control interface 5 in the form of a further acoustic alarm. The prompting element 4 informs the operator that the pulse ceases to be regular and, hence, that there is a potential interference between the MRI and the pacemaker 2. Further, the control interface 5 will stop the MRI examination. Therewith, the interference of the MRI activation and the pacemaker 2 is minimized.

The operator can then examine the patient 12 to ensure that no complications arose. The pacemaker 2 might again be set in an asynchronous mode and the MRI examination might continue. The MRI examination might alternatively be performed another time.

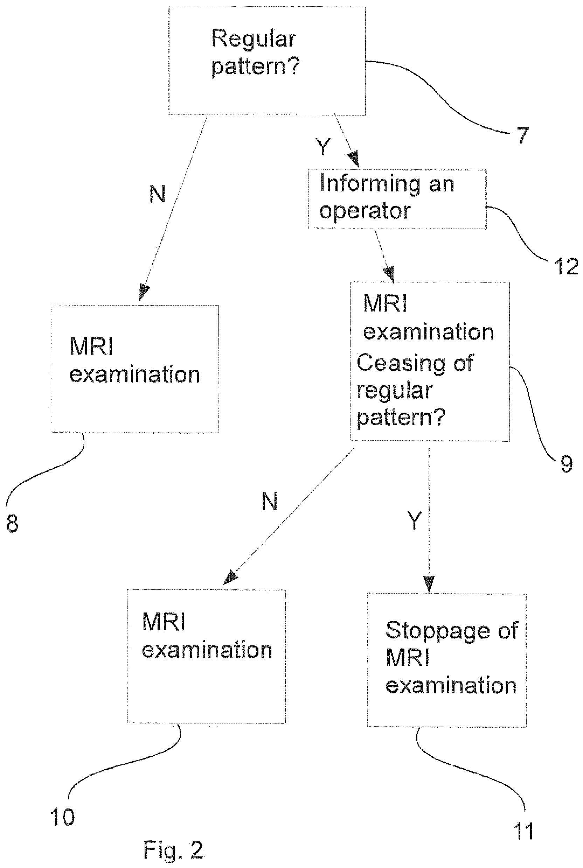

Figure 2 shows a flowchart illustrating a decision process according to the invention. In step 7 a monitor 3 determines if a patient is having a regular spike pattern.. If no spike pattern is detected (N), the patient is not wearing a pacemaker in asynchronous mode and the MRI examination is started 8. If spikes are detected, which are not in a regular pattern the operator is informed (not shown). Further, if there are more than 100 spikes per minute the user is informed even if the spikes fulfil a regularity pattern (not shown).

If a regular pattern is detected (Y), a user of the MRI device is informed that the patient is wearing a pacemaker 12. The MRI examination is started while continuing to measure the pulse of the patient 9. If the pulses ceases to be regular (Y), the MRI device is stopped by a control interface and the user is informed accordingly 11. The user is also informed if more than 100 spikes per minute are detected. If the pulse continues to be regular, the MRI examination runs until the end 10 or until a non-regular pattern is detected.

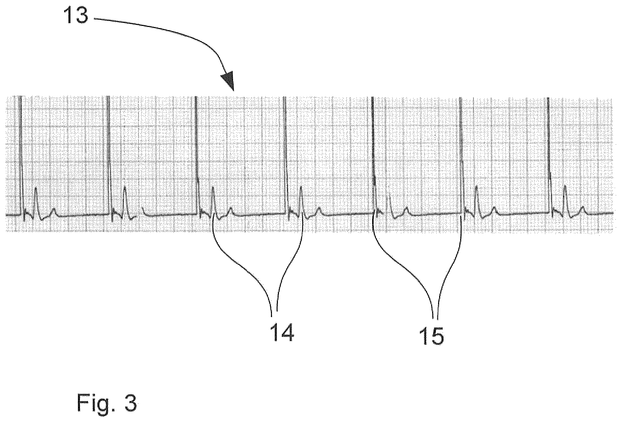

Figure 3 shows an ECG diagram of an asynchronous pattern 13. The ECG diagram shows the pulse of the patient 14. Further, the diagram shows ventricular pacemaker spikes 15. The spikes 15 have a regular distance, which arises in asynchronous set pacemakers.

## Claims

1. A method for determining if an implanted pacemaker set in asynchronous mode (2) is present, said method being carried out with an ECG monitor (3), comprising the steps of:
- before an MRI examination, automatically detecting emitted spikes (15) of the pacemaker (2) with the ECG monitor (3),
**characterized in that** the method comprises the further steps of
- checking for spikes with a regularly pattern when the patient is in a MRI tube but before the MRI examination starts by determining by the ECG monitor if the monitored spikes (15) fulfil a predetermined regularity pattern,
- informing an operator, preferably visually and/or acoustically, if the spikes (15) fulfil the predetermined regularity pattern with a prompting device (4).

2. The method according to claim 1, wherein emitted spikes (15) of the pacemaker (2) are automatically detected during MRI examination with the ECG monitor (3).

3. The method according to claim 1, wherein it is determined if a QRS pulse is present after the monitored spikes (15).

4. The method according to any of claims 1 to 3, comprising the further step of informing an operator, preferably visually and/or acoustically, if a QRS pulse is present or not after any of the spikes (15) with the prompting device (4).

5. The method according to any of claims 2 to 4, comprising the further step of informing an operator, preferably visually and/or acoustically, if the spikes (15) do not fulfil the predetermined regularity pattern anymore with a prompting device (4) if a regularity pattern had previously been detected.

6. The method according to any of the claims 2 to 4, comprising the further step of generating a stop signal for stopping the MRI examination device if the ECG monitor (3) detects spikes (15) not fulfilling such regularity pattern anymore if a regularity pattern had previously been detected.

7. The method according to one of the preceding claims, comprising the further step of detecting the presence of switching magnetic field gradients of a magnet field used for magnetic resonance imaging with a magnetic field variation detector.

8. The method according to claim 7, comprising the further step of detecting an impulse response between a disturbance input and an artefact caused by a magnetic field gradient of the MRI system used for magnetic resonance imaging on an ECG trace.

9. The method according to any of the preceding claims, wherein the monitor is used as an add-on to an MRI-device.

10. An MRI device (1) for use with a patient (12) having an implanted heart pacemaker (2), wherein the MRI device comprises an ECG monitor (3) configured to automatically detect emitted spikes (15) of a pacemaker (2) set in asynchronous mode before and/or during MRI examination, **characterized in that**, the ECG monitor is further configured to determine if the detected spikes (15) fulfil a predetermined regularity pattern, wherein the ECG monitor comprises a prompting element (4) configured to inform an operator, preferably visually and/or acoustically if spikes (15) fulfilling the regularity pattern are present.

11. The MRI device (1) according to claim 10, wherein the ECG monitor is further is configured to determine if a QRS pulse is present after the detected spikes (15).

12. The MRI device (1) according to claim 10 or 11, wherein the prompting element (4) is configured to inform the operator, if a QRS pulse is present after any of the spikes (15) or not.

13. The MRI device (1) according to claim 10, wherein the prompting element (4) is configured to provide an alarm, preferably a visual and/or an acoustic alarm, to the operator in case of detected spikes (15) not fulfilling the predetermined regularity pattern anymore if a regularity pattern had previously been detected.

14. The MRI device (1) according to any of the claims 10 to 13, wherein the device further comprises a control interface (5) configured to stop an MRI examination in case of non-fulfilment of such regularity pattern if a regularity pattern had previously been detected.

15. The MRI device (1) according to any of the claims 10 to 14, wherein the ECG monitor (3) comprises a magnetic field variation detector to detect the presence of switching magnetic field gradients of a magnetic field used for magnetic resonance imaging.

16. The MRI device (1) according to claim 15, wherein the monitor (3) comprises a disturbance input and is able to detect an impulse response between the disturbance input and the artefact caused by switching magnetic field gradients of a magnetic field used for magnetic resonance imaging on an ECG trace.

## Patentansprüche

1. Verfahren zur Bestimmung des Vorhandenseins eines implantierten Herzschrittmachers (2) im asynchronen Modus, wobei das Verfahren mit einem EKG-Monitor (3) durchgeführt wird, mit den folgenden Schritten:
- automatisches Erkennen von emittierten Spikes (15) des Herzschrittmachers (2) mit dem EKG-Monitor (3) vor einer MRT-Untersuchung,
**dadurch gekennzeichnet, dass** das Verfahren die folgenden weiteren Schritte umfasst
- Prüfen auf Spikes mit einem regelmäßigen Muster, wenn sich der Patient in einer MRT-Röhre befindet, aber bevor die MRT-Untersuchung beginnt, indem durch den EKG-Monitor bestimmt wird, ob die überwachten Spikes (15) ein vorbestimmtes Regelmäßigkeitsmuster erfüllen,
- Benachrichtigung eines Bedieners, vorzugsweise visuell und/oder akustisch, wenn die Spikes (15) das vorbestimmte Regelmäßigkeitsmuster erfüllen, mit einer Promptingeinrichtung (4).

2. Verfahren nach Anspruch 1, wobei emittierte Spikes (15) des Herzschrittmachers (2) während der MRT-Untersuchung mit dem EKG-Monitor (3) automatisch erkannt werden.

3. Verfahren nach Anspruch 1, wobei festgestellt wird, ob nach den überwachten Spikes (15) ein QRS-Puls vorhanden ist.

4. Verfahren nach einem der Ansprüche 1 bis 3, mit dem weiteren Schritt, einem Bediener mit der Promptingeinrichtung (4), vorzugsweise visuell und/oder akustisch mitzuteilen, ob nach einem der Spikes (15) ein QRS-Puls vorhanden ist oder nicht.

5. Verfahren nach einem der Ansprüche 2 bis 4, mit dem weiteren Schritt, einen Bediener, vorzugsweise visuell und/oder akustisch, mit einer Prompting-einrichtung (4) zu informieren, wenn die Spikes (15) das vorgegebene Regelmäßigkeitsmuster nicht mehr erfüllen, wenn zuvor ein Normalitätsmuster erkannt worden war.

6. Verfahren nach einem der Ansprüche 2 bis 4, umfassend den weiteren Schritt des Erzeugens eines Stoppsignals zum Anhalten des MRT-Untersuchungsgeräts, wenn der EKG-Monitor (3) Spikes (15) detektiert, die ein solches Normalitätsmuster nicht mehr erfüllen, wenn zuvor ein Normalitätsmuster detektiert wurde.

7. Verfahren nach einem der vorhergehenden Ansprüche, umfassend den weiteren Schritt des Erkennens des Vorhandenseins von schaltenden Magnetfeldgradienten eines für die Magnetresonanztomographie verwendeten Magnetfeldes mit einem Magnetfeldvariationsdetektor.

8. Verfahren nach Anspruch 7, umfassend den weiteren Schritt des Erfassens einer Impulsantwort zwischen einem Störeingang und einem Artefakt, das durch einen Magnetfeldgradienten des für die Magnetresonanztomographie verwendeten MRI-Systems verursacht wird, auf einer EKG-Spur.

9. Verfahren nach einem der vorhergehenden Ansprüche, wobei der Monitor als Zusatzgerät zu einem MRI-Gerät verwendet wird.

10. MRT-Gerät (1) zur Verwendung bei einem Patienten (12) mit einem implantierten Herzschrittmacher (2), wobei die MRT-Vorrichtung einen EKG-Monitor (3) umfasst, der so konfiguriert ist, dass er vor und/oder während einer MRT-Untersuchung automatisch emittierte Spitzen (15) eines in einen asynchronen Modus versetzten Schrittmachers (2) erfasst, **dadurch gekennzeichnet, dass**, der EKG-Monitor ferner konfiguriert ist, um zu bestimmen, ob die detektierten Spikes (15) ein vorbestimmtes Normalitätsmuster erfüllen, wobei der EKG-Monitor ein Prompting-Element (4) umfasst, das konfiguriert ist, um einen Bediener vorzugsweise visuell und/oder akustisch zu informieren, wenn Spikes (15), die das Normalitätsmuster erfüllen, vorher gesendet werden.

11. MRT-Gerät (1) nach Anspruch 10, wobei der EKG-Monitor ferner so konfiguriert ist, dass er feststellt, ob nach den detektierten Spikes (15) ein QRS-Puls vorhanden ist.

12. MRT-Gerät (1) nach Anspruch 10 oder 11, wobei das Prompting-Element (4) so konfiguriert ist, dass es dem Bediener mitteilt, ob ein QRS-Puls nach einer der Spikes (15) vorhanden ist oder nicht.

13. MRT- Gerät (1) nach Anspruch 10, wobei das Prompting-Element (4) so konfiguriert ist, dass es einen Alarm, vorzugsweise einen visuellen und/oder einen akustischen Alarm, für den Operateur auslöst, wenn die detektierten Spikes (15) nicht mehr das vorbestimmte Normalitätsmuster erfüllen, wenn zuvor ein Normalitätsmuster detektiert worden war.

14. MRT-Gerät (1) nach einem der Ansprüche 10 bis 13, wobei das Gerät ferner eine Steuerschnittstelle (5) umfasst, die so konfiguriert ist, dass sie eine MRT-Untersuchung im Falle der Nichterfüllung eines solchen Normalitätsmusters stoppt, wenn zuvor ein Normalitätsmuster erkannt worden war.

15. MRT-Gerät (1) nach einem der Ansprüche 10 bis 14, wobei der EKG-Monitor (3) einen Magnetfeldvariationsdetektor umfasst, um das Vorhandensein von wechselnden Magnetfeldgradienten eines für die Magnetresonanztomographie verwendeten Magnetfeldes zu erkennen.

16. MRT-Vorrichtung (1) nach Anspruch 15, wobei der Monitor (3) einen Störeingang umfasst und in der Lage ist, eine Impulsantwort zwischen dem Störeingang und dem Artefakt zu erfassen, der durch wechselnde Magnetfeldgradienten des für die Magnetresonanz-Bildgebung verwendeten Magnetfelds auf einer EKG-Spur verursacht wird.

## Revendications

1. Procédé pour déterminer si un stimulateur cardiaque implanté réglé en mode asynchrone (2) est présent, ledit procédé étant mis en oeuvre avec un moniteur ECG (3), comprenant les étapes consistant à :
- avant un examen IRM, détecter automatiquement les pointes émises (15) du stimulateur cardiaque (2) avec le moniteur ECG (3),
**caractérisé en ce que** le procédé comprend les étapes supplémentaires suivantes
- vérifier les pointes avec un modèle régulier lorsque le patient est dans un tube IRM mais avant que l'examen IRM ne commence en déterminant par le moniteur ECG si les pointes surveillées (15) remplissent un modèle de régularité prédéterminé,
- informant un opérateur, de préférence visuellement et/ou acoustiquement, si les pointes (15) remplissent le modèle de régularité prédéterminé avec un dispositif d'invite (4).

2. Procédé selon la revendication 1, dans lequel les pointes émises (15) du stimulateur cardiaque (2) sont automatiquement détectées pendant l'examen IRM avec le moniteur ECG (3) .

3. Procédé selon la revendication 1, dans lequel on détermine si une impulsion QRS est présente après les pointes surveillés (15).

4. Procédé selon l'une quelconque des revendications 1 à 3, comprenant l'étape supplémentaire consistant à informer un opérateur, de préférence visuellement et/ou acoustiquement, si une impulsion QRS est présente ou non après l'un quelconque des pointes (15) avec le dispositif d'invite (4).

5. Procédé selon l'une quelconque des revendications 2 à 4, comprenant l'étape supplémentaire consistant à informer un opérateur, de préférence visuellement et/ou acoustiquement, si les pointes (15) ne remplissent plus le modèle de régularité prédéterminé avec un dispositif d'invite (4) si un modèle de régularité avait été précédemment détecté.

6. Procédé selon l'une quelconque des revendications 2 à 4, comprenant l'étape supplémentaire consistant à générer un signal d'arrêt pour arrêter le dispositif d'examen IRM si le moniteur ECG (3) détecte des pointes (15) ne remplissant plus un tel modèle de régularité si un modèle de régularité avait été précédemment détecté.

7. Procédé selon l'une des revendications précédentes, comprenant l'étape supplémentaire consistant à détecter la présence de gradients de champ magnétique de commutation d'un champ magnétique utilisé pour l'imagerie par résonance magnétique avec un détecteur de variation de champ magnétique.

8. Procédé selon la revendication 7, comprenant l'étape supplémentaire consistant à détecter une réponse impulsionnelle entre une entrée de perturbation et un artefact causé par un gradient de champ magnétique du système d'IRM utilisé pour l'imagerie par résonance magnétique sur un tracé ECG.

9. Procédé selon l'une quelconque des revendications précédentes, dans lequel le moniteur est utilisé comme une extension d'un dispositif d'IRM.

10. Dispositif d'IRM (1) destiné à être utilisé avec un patient (12) ayant un stimulateur cardiaque implanté (2), dans lequel le dispositif d'IRM comprend un moniteur d'ECG (3) configuré pour détecter automatiquement des pointes émises (15) d'un stimulateur cardiaque (2) réglé en mode asynchrone avant et/ou pendant un examen d'IRM, **caractérisé en ce que** le moniteur ECG est en outre configuré pour déterminer si les pointes détectées (15) remplissent un modèle de régularité prédéterminé, dans lequel le moniteur ECG comprend un élément d'invite (4) configuré pour informer un opérateur, de préférence visuellement et/ou acoustiquement, si des pointes (15) remplissant le modèle de régularité sont présentées.

11. Dispositif IRM (1) selon la revendication 10, dans lequel le moniteur ECG est en outre configuré pour déterminer si une impulsion QRS est présente après les pointes détectées (15) .

12. Dispositif d'IRM (1) selon la revendication 10 ou 11, dans lequel l'élément d'invite (4) est configuré pour informer l'opérateur, si une impulsion QRS est présente après l'une des pointes (15) ou non.

13. Dispositif d'IRM (1) selon la revendication 10, dans lequel l'élément d'invite (4) est configuré pour fournir une alarme, de préférence une alarme visuelle et/ou acoustique, à l'opérateur dans le cas de pointes détectées (15) ne remplissant plus le modèle de régularité prédéterminé si un modèle de régularité avait été précédemment détecté.

14. Dispositif d'IRM (1) selon l'une quelconque des revendications 10 à 13, dans lequel le dispositif comprend en outre une interface de commande (5) configurée pour arrêter un examen d'IRM en cas de non-réalisation d'un tel modèle de régularité si un modèle de régularité avait été précédemment détecté.

15. Dispositif IRM (1) selon l'une quelconque des revendications 10 à 14, dans lequel le moniteur ECG (3) comprend un détecteur de variation de champ magnétique pour détecter la présence de gradients de champ magnétique de commutation d'un champ magnétique utilisé pour l'imagerie par résonance magnétique.

16. Dispositif d'IRM (1) selon la revendication 15, dans lequel le moniteur (3) comprend une entrée de perturbation et est capable de détecter une réponse impulsionnelle entre l'entrée de perturbation et l'artefact causé par la commutation des gradients de champ magnétique d'un champ magnétique utilisé pour l'imagerie par résonance magnétique sur un tracé ECG.
